# EUROPÄISCHE PATENTSCHRIFT

(11) **EP 0 307 345 B1**
(45) Veröffentlichungstag und Bekanntmachung des Hinweises auf die Patenterteilung: **18.11.1993**
(21) Anmeldenummer: 88730196.8
(22) Anmeldetag: 05.09.1988
(51) Int. Cl.: H04L 25/20, G08C 19/16

(54) **Schaltungsanordnung zur Übertragung von Sendeimpulsen zwischen zwei galvanisch getrennten Stromkreisen**
Circuit arrangement for the transmission of pulses between two galvanically separated circuits
Circuit pour la transmission d'impulsions entre deux circuits galvaniquement isolés

(30) Priorität: 11.09.1987 DE 3731020
(43) Veröffentlichungstag der Anmeldung: 15.03.1989
(73) Patentinhaber: SIEMENS AKTIENGESELLSCHAFT, 80333 München (DE)
(72) Erfinder: Buchholz, Udo-Fritz, Dipl.-Ing., D-1000 Berlin 36 (DE); Lesche, Wolfgang, Dipl.-Ing., D-1000 Berlin 37 (DE)

(56) Entgegenhaltungen:
- DE-A- 3 210 509
- DE-A- 3 614 832
- NEUES AUS DER TECHNIK, 15. September 1981, Nr. 4/5, Seite 2: "Magnetische Kopplung zur Übertragung digitaler Signale"

## Beschreibung

Die Erfindung bezieht sich auf eine Schaltungsanordnung zur Übertragung von Sendeimpulsen zwischen zwei galvanisch getrennten Stromkreisen mit einem Impuls-Übertrager, dessen Primärwicklung über einen Impulsformer mit einem niederkapazitiven Kondensator in Reihe geschaltet ist und an dessen Sekundärwicklung ein Schwellwertschalter angeschlossen ist, an dessen Ausgang die Übertragerimpulse abgreifbar sind.

Bei einer bekannten Schaltungsanordnung dieser Art (Notiz "Magnetische Kopplung zur Übertragung digitaler Signale" in der Zeitschrift "Neues aus der Technik", 15.09.1981, Nr. 4/5, Seite 2) erfolgt auf der Sekundärseite eine Mitkopplung über einen ohmschen Widerstand. Dies beeinträchtigt die Übertragung kurzer bzw. steiler Impulse; außerdem treten Leistungsverluste ein.

Aus der Produktbeschreibung "SNT-Control-Ship-Set vereinfacht Konstruktion von isolierten Schaltreglern" (Zeitschrift 'Elektronik Informationen" Nr. 11 -1986, Seiten 84 bis 87) ist ferner eine Schaltungsanordnung bekannt, bei der es sich um eine Schaltungsanordnung mit einem Impuls-Übertrager zur Regelung der Sekundärspannung eines Leistungs-Übertragers durch Veränderung des Tastverhältnisses dessen primärseitiger Leistungsimpulse handelt. Hierbei wird die Regelabweichung auf der Sekundärseite des Leistungs-Übertragers von einem PWM-Komparator in einen Sendeimpuls mit einem entsprechenden Tastverhältnis umgesetzt und über einen niederkapazitiven Kondensator zur Unterdrückung von Gleichstromanteilen (Verminderung der Sendeleistung) der Primärwicklung des Impuls-Übertragers zugeführt. Dieser differenziert und invertiert den Sendeimpuls und stellt an seiner Sekundärwicklung, an die ein weiterer Kondensator angeschlossen ist, einen entsprechenden Übertragerimpuls zur Verfügung, der der Regelung des Leistungs-Übertragers dient.

Die Erfindung sieht bei einer Schaltungsanordnung der oben angegebenen Art erfindungsgemäß vor, daß der Schwellwertschalter direkt über die Sekundärwicklung mitgekoppelt ist.

Die erfindungsgemäße Schaltungsanordnung ist in vorteilhafter Weise einfach und daher kostengünstig bei gleichzeitiger Gewährleistung optimaler und schneller Impulsübertragung bzw. Übertragung der Tastverhältnisse der Sendeimpulse. Im Vergleich zu der eingangs an erster Stelle behandelten, bekannten Schaltungsanordnung kommt die erfindungsgemäße Schaltungsanordnung mit erheblich weniger Bauelementen aus; während bei der bekannten Anordnung auf der Sekundärseite vier Widerstände vorhanden sind, benötigt die erfindungsgemäße Schaltungsanordnung sekundärseitig derartige Widerstände überhaupt nicht. Darüber hinaus ist darauf hinzuweisen, daß die erfindungsgemäße Schaltungsanordnung auf der Sekundärseite leistungslos arbeitet, weil Widerstände entfallen. Die Übertragerimpulse sind phasengleich zu den Sendeimpulsen mit nur minimaler Fehlerabweichung in den Tastverhältnissen. Es können mit der erfindungsgemäßen Übertrager-Schaltungsanordnung Tastverhältnisse beliebiger Rechteckimpulse oder von Impulsen anderer Form (z. B. sinusförmiger) übertragen werden, wobei die Impulse zwar eine Mindestpulsbreite aufweisen müssen, in ihrer Dauer und zeitlichen Abfolge jedoch beliebig sein können. Insbesondere können vorteilhaft einer Meßgröße proportionale Tastverhältnisse von Rechteckspannungen schnell und relativ fehlerfrei zwischen zwei galvanisch getrennten Stromkreisen übertragen werden.

Als Schwellwertschalter kann bei der erfindungsgemäßen Schaltungsanordnung beispielsweise ein einfacher Operationsverstärker verwendet werden. Der Schwellwertschalter kann aber auch gemäß einer weiteren vorteilhaften Ausgestaltung der Erfindung ein logisches Gatter sein, welches nur mit einer Eingangsgröße (den Sendeimpulsen) beaufschlagt ist. Vorteilhafter ist aber, wenn nach einer anderen Ausgestaltung der erfindungsgemäßen Schaltungsanordnung auch der Schwellwertschalter ein Leitungstreiber (Buffer) ist. Dies ermöglicht in vorteilhafter Weise die schnelle Erzeugung besonders steiler Übertragerimpulse.

Bei der erfindungsgemäßen Schaltungsanordnung kann der Impuls-Übertrager eine sehr kleine Induktivität aufweisen. Es ist daher entsprechend einer anderen vorteilhaften Ausgestaltung der erfindungsgemäßen Schaltungsanordnung günstig, wenn die Primär- und Sekundärwicklung des Impuls-Übertragers jeweils eine sehr geringe Windungszahl aufweisen. Es kann sich hierbei um eine einzige Windung oder auch um zwei Windungen handeln. Bei einer derartig geringen Windungsanzahl ist z. B. die Verwendung eines sehr preisgünstigen und einfachen Doppellochkerns als Kern für den Impuls-Übertrager möglich.

Ist jedoch die erfindungsgemäße Schaltungsanordnung Teil einer Anordnung mit einem Leistungs-Übertrager, dann ist es vorteilhaft, wenn die Primär- und Sekundärwicklung des Impuls-Übertragers auf den Kern des Leistungs-Übertragers derart aufgebracht sind, daß die Impulsübertragung von dem Magnetfluß des Leistungs-Übertragers unbeeinflußt bleibt. Gerade bei einer geringen Windungsanzahl läßt sich dies bei herkömmlichen Kernen in einfacher Weise verwirklichen; z. B. kann bei Schalenkernen das Mittelloch mit beispielsweise den beiden Windungen der Primär- und Sekundärwicklung durchsetzt sein. Bei dieser zweifachen Verwendung ein und desselben Kerns ist jedoch darauf zu achten, daß der Nutzfluß des Leistungs-Übertragers die Impulsübertragung nicht beeinflußt und umgekehrt.

Die erfindungsgemäße Schaltungsanordnung kann jedoch auch als integraler Bestandteil einer gedruckten Schaltung eingesetzt werden, wenn nach einer anderen vorteilhaften Ausgestaltung der erfindungsgemäßen Schaltungsanordnung die Primär- und Sekundärwicklung des Impuls-Übertragers aus jeweils einer auf einer gedruckten Leiterplatte aufgebrachten schleifenartigen Leiterbahn bestehen und der Kern des Impuls-Übertragers von einem beide schleifenartige Leiterbahnen durchsetzenden Stift aus magnetisch leitendem Material gebildet ist. Ein derartiger Impuls-Übertrager ist dann besonders einfach herzustellen, zumal sein Kern nunmehr aus einem einfachen Stift besteht. Der Kern kann aber auch - zur Vermeidung gegebenenfalls auftretender Störungen - geschlossen ausgeführt sein. In den Größenabmessungen paßt sich ein derartiger Impuls-Übertrager besonders gut denen der gedruckten Schaltung an. Das Aufdrucken der die Primär- und Sekundärwicklung bildenden Leiterbahnen ist in entsprechender Anordnung auf einer oder auf verschiedenen Seiten einer Leiterplatte möglich.

Gemäß einer anderen Ausgestaltung der erfindungsgemäßen Schaltung ist es weiterhin vorteilhaft, wenn der Impulsformer von einem Speicherkondensator, dem über eine Gleichrichterdiode die Sendeimpulse zugeführt sind, gespeist ist. Bei dieser Ausgestaltung ist eine externe Speisequelle für den Impulsformer nicht mehr erforderlich. Es muß jedoch gewährleistet sein, daß die Sendeimpulse eine derart hohe Folge aufweisen, daß eine ständige Speisung erfolgt. Es ist dies beispielsweise bei der digitalen Datenübertragung im Telegrammverkehr der Fall. Weiterhin ist auch zur Sicherstellung der Speisung das Einhalten einer Mindestpulsbreite für die Sendeimpulse erforderlich.

Anhand der Figuren wird die erfindungsgemäße Schaltungsanordnung zur Übertragung von Sendeimpulsen in bevorzugten Ausführungsbeispielen nachfolgend erläutert.

Es zeigen dabei die
- - Fig. 1: das Schaltbild eines Ausführungsbeispiels der erfindungsgemäßen Schaltungsanordnung,
- - Fig. 2: die Spannungsverläufe für die Sendeimpulse, die Kondensatorladung und die Übertragerimpulse an demselben Ausführungsbeispiel,
- - Fig. 3: das Schaltbild eines Ausführungsbeispieles für eine interne Speisung des Impulsformers und
- - Fig. 4: den Querschnitt und die Draufsicht eines Ausführungsbeispiels einer gedruckten Leiterplatte mit einem Ausführungsbeispiel der erfindungsgemäßen Schaltungsanordnung.

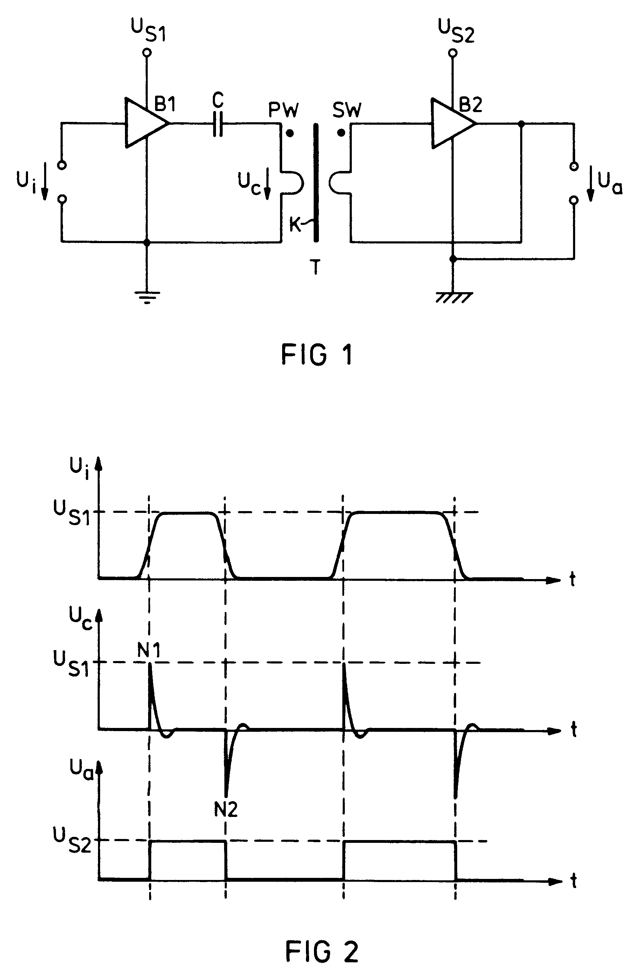

In der Figur 1 ist ein Impuls-Übertrager T dargestellt, der eine Primärwicklung PW, eine Sekundärwicklung SW und einen Kern K enthält. Insbesondere weisen wegen der angestrebten geringen Induktivität des Impuls-Übertragers T Primär- und Sekundärwicklung PW und SW nur eine einzige Windung auf, so daß der Kern K klein in seinen Abmaßen und einfach in seiner Form gestaltet sein kann, beispielsweise ein einfacher preisgünstiger Doppellochkern sein kann. In Reihe zu der Primärwicklung PW und dieser vorgeschaltet ist ein Kondensator C mit niedriger Kapazität. Dem Kondensator wiederum vorgeschaltet ist ein Impulsformer B1.

Dieser Impulsformer B1 ist insbesondere ein Leitungstreiber (Buffer). Gespeist wird der aktive Leitungstreiber B1 (Buffer) mit einer Speisespannung U_{S1}. Der Sekundärwicklung SW ist ein Schwellwertschalter B2 nachgeschaltet. Dieser ist ebenfalls ein Leitungstreiber (Buffer). Gespeist wird dieser Leitungstreiber B2 (Buffer) mit einer Speisespannung U_{S2}. Der Leitungstreiber B2 (Buffer) ist weiterhin so geschaltet, daß er über die Sekundärwicklung SW mitgekoppelt ist.

Auf der linken Seite der Schaltungsanordnung gemäß Fig. 1 werden Sendeimpulse als Eingangsspannung Uᵢ eingespeist. Diese werden von dem Leitungstreiber B1 gegebenbenfalls aufbereitet, d. h. die Steilheit ihrer Flanken wird verbessert. Die Sendeimpulse, die eine Mindestpulsbreite übersteigen müssen, können daher einen nahezu beliebigen Verlauf aufweisen. Aufgrund der Speisespannung U_{S1} des Leitungstreibers B1 (Buffers) haben die zu übertragenden "aufgefrischten" Sendeimpulse (Rechteckimpulse) eine Höhe von U_{S1}. Mit diesen wird dann der Kondensator C mit entsprechender Polarität geladen. Im gewählten Ausführungsbeispiel erzeugen beispielsweise ansteigende Flanken der zu übertragenden Sendeimpulse eine Ladung des Kondensators mit einer ersten Polarität und abfallende Flanken eine Ladung des Kondensators C mit entgegengesetzter Polarität.

Da der Kondensator C eine nur sehr geringe Kapazität, beispielsweise 220 pF aufweist, entlädt er sich sehr schnell über die zu dem Kondensator C in Reihe geschaltete Primärwicklung PW des Impuls-Übertragers T. Aufgrund des inneren Widerstandes der Schaltung, insbesondere aber des niedrigen Ausgangswiderstandes des Leitungstreibers B1 (Buffer), ist die Dämpfung der Entladeschwingung des Kondensators C relativ stark, so daß dieser der Primärwicklung PW des Impuls-Übertragers T eine Kondensatorspannung U_{c} in Form von Nadelimpulsen mit entsprechender Polarität aufprägt. Diese Nadelimpulse werden von der Primärwicklung PW des Impuls-Übertragers T auf die Sekundärwicklung SW übertragen.

Die übertragenen Sendeimpulse in Form von Nadelimpulsen gelangen dann auf den zweiten Leitungstreiber B2, der die Übertragerimpulse bildet. Handelt es sich bei dem Leitungstreiber B2 um ein nichtinvertierendes Bauelement, führen positive Sendeimpulse dazu, daß der Leitungstreiber B2 (Buffer) beispielsweise von seiner Ausgangsstellung mit einem unteren Schwellen-Niveau auf eine Stellung mit einem oberen Schwellen-Niveau springt, wobei die Höhe dieses Niveaus der Speisespannung U_{S2} entspricht. Voraussetzung hierfür ist natürlich, daß die Höhe des übertragenen Sendeimpulses größer ist als die Schwellenspannung. Da der zweite Leitungstreiber B2 über die Sekundärwicklung SW mitgekoppelt ist, verbleibt er auf dem oberen Schwellen-Niveau, bis ein zweiter übertragener Sendeimpuls mit umgekehrter Polarität ihn wieder auf das untere Schwellen-Niveau rücksetzt. Im beschriebenen Fall werden die Übertragerimpulse mit gleicher Polarität wie die Sendeimpulse gebildet, weil auch der Wicklungssinn von Primär- und Sekundärwicklung gleich ist. Bei einem unterschiedlichen Wicklungssinn erhält man zu zu den Sendeimpulsen entgegengesetzt polarisierte Übertragerimpulse.

Mit der erfindungsgemäßen Schaltungsanordnung können also Tastverhältnisse mit sehr hoher Genauigkeit übertragen werden. Dieses ist besonders vorteilhaft, wenn die Tastverhältnisse beispielsweise von einer Meßgröße proportionalen Sendeimpulsen in Form von Rechteckspannungen stammen. Die damit erzeugten Übertragerimpulse in Form einer Ausgangsspannung Uₐ sind dann phasengleich mit den Sendeimpulsen in Form der Eingangspannung Uᵢ, und die Veränderung des Tastverhältnisses liegt aufgrund der extrem kurzen Schaltzeiten der Leitungstreiber B1 und B2 (Buffer) nur bei einem Fehler im Nanosekundenbereich.

In der Figur 2 sind die Verläufe der Sendeimpulse als Einspannungsspannung Uᵢ, der vom Kondensator C der Primärwicklung PW aufgeprägten Nadelimpulse als Kondensatorspannung U_{c} und die Übertragerimpulse als Ausgangsspannungsspannung Uₐ über der Zeit aufgetragen. Die Eingangsspannung Uᵢ wird für jeden Sendeimpuls günstigerweise ungefähr mit der Höhe der Speisespannung U_{S1} über den Leitungstreiber B1 und den Kondensator C in dessen Anstiegsflanke in einen positiven Nadelimpuls N₁ und in seiner Abstiegsflanke in einen negativen Nadelimpuls N₂ umgesetzt. Diese Nadelimpulse N₁ und N₂ mit ihrer entsprechenden Polarität werden vom Impuls-Übertrager T übertragen und führen dazu, daß der Leitungstreiber B2 eine den Übertragersignalen entsprechende Ausgangsspannung Uₐ mit einer Höhe der Speisespannung U_{S2} erzeugt. Bei Eintreffen des Nadelimpulses N₁ wird der Leitungstreiber B2 dabei auf sein oberes Schwellen-Niveau gesetzt, bei Eintreffen des Nadelimpulses N₂ wird er wieder auf sein unteres Schwellen-Niveau rückgesetzt.

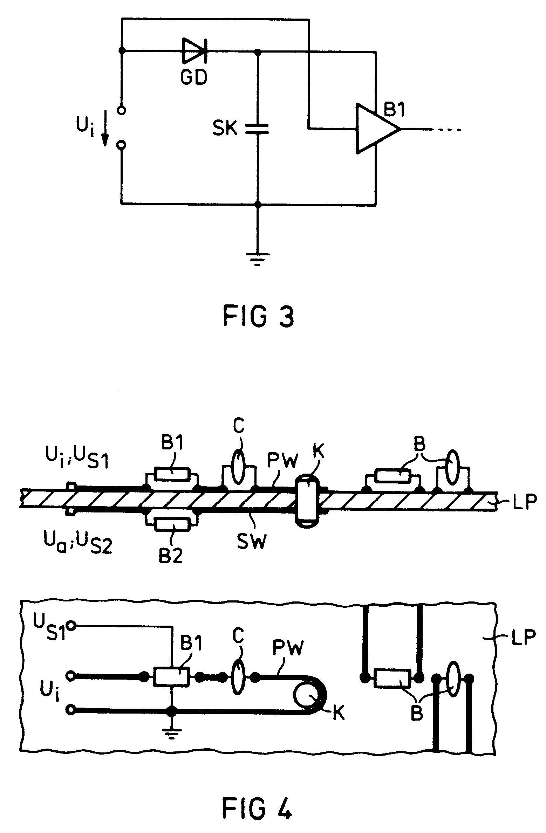

In Fig. 3 ist eine interne Speisung des Impulsformers bzw. Leitungstreibers B1 dargestellt. Diese erfolgt über eine Gleichrichterdiode GD und einen Speicherkondensator SK, die dem Impulsformer bzw. Leitungstreiber B1 vorgeschaltet sind. Voraussetzung für eine solche interne Speisung ist jedoch, daß die Sendeimpulse mit einer derartigen Häufigkeit auftreten, daß eine dauernde Leistungsversorgung des Impulsformers bzw. Leitungstreibers B1 gewährleistet ist. Es ist insbesondere dies der Fall bei der Datenübertragung im Telegrammverkehr.

Aufgrund der kleinen Kapazität des in der erfindungsgemäßen Schaltungsanordnung vorhandenen Kondensators ist auch der Gesamtstrombedarf des Impuls-Übertragers sehr gering und liegt im Mikroamperebereich (z. B. beträgt bei einer Kapazität von 220 pF, einer Übertragungsfrequenz von 10 kHz und einer Speisespannung für den Impulsformer von 5V der Strom 11 µA). Die maximale Übertragungsfrequenz der erfindungsgemäßen Schaltungsanordnung liegt je nach Schaltungsausführung zwischen 10 und 30 MHz. Sie ist begrenzt durch die Anstiegs- und Laufzeiten des Impulsformers und des Schwellwertschalters. Die Laufzeit eines Sendeimpulses über derartige Bauelemente (z. B. Leitungstreiber (Buffer) in HCmos-Technik beträgt ca. 20 ns. Die Induktivität des Impuls-Übertragers hat eine Größe von ungefähr 3 µH.

Die Figur 4 zeigt ein Ausführungsbeispiel einer gedruckten Leiterplatte LP mit einem Ausführungsbeispiel der erfindungsgemäßen Schaltungsanordnung. Neben anderen Bauelementen B ist auf der Oberseite der Leiterplatte LP eine die Primärwicklung des Impuls-Übertragers T bildende schleifenartige Leiterbahn PW aufgedruckt, in die der Impulsformer B1 und der Kondensator C liegen sind und deren Schleifenkopf von einem den Kern des Impuls-Übertragers bildenden Stift K aus magnetisch leitendem Material, insbesondere Ferrit, durchsetzt ist. Auf der Unterseite der Leiterplatte LP ist eine die Sekundärwicklung bildende zweite Leiterbahn SW aufgedruckt, die zu dem Schwellwertschalter B2 führt und die ebenfalls in ihrem Schleifenkopf von dem Stift K durchsetzt ist. Die Anschlüsse (Uᵢ, U_{S1}, U_{S2}, Uₐ) der Schaltungsanordnung entsprechen denen in Fig. 1. Dadurch, daß bei der erfindungsgemäßen Schaltungsanordnung nur eine sehr kleine Kapazität und Induktivität benötigt werden, läßt sich diese mit ihren einfachen Bauteilen - insbesondere mit dem einfachen Kern in Form eines Stiftes K -einfach auf einer gedruckten Leiterplatte LP integrieren.

## Patentansprüche

1. Schaltungsanordnung zur Übertragung von Sendeimpulsen zwischen zwei galvanisch getrennten Stromkreisen mit einem Impuls-Übertrager (T), dessen Primärwicklung (PW) über einen Impulsformer (B1) mit einem niederkapazitiven Kondensator (C) in Reihe geschaltet ist und an dessen Sekundärwicklung (SW) ein Schwellwertschalter (B2) angeschlossen ist, an dessen Ausgang die Übertragerimpulse abgreifbar sind,
**dadurch gekennzeichnet,** daß der Schwellwertschalter (B2) direkt über die Sekundärwicklung (SW) mitgekoppelt ist.

2. Schaltung nach Anspruch 1,
**dadurch gekennzeichnet,** daß der Schwellwertschalter ein logisches Gatter ist.

3. Schaltung nach Anspruch 1 oder 2, **dadurch gekennzeichnet,** daß der Schwellwertschalter ein Leitungstreiber (B2) (Buffer) ist.

4. Schaltung nach einem der vorangehenden Ansprüche,
**dadurch gekennzeichnet,** daß die Primär-und Sekundärwicklung (PW, SW) des Impuls-Übertragers (T) jeweils eine sehr geringe Windungszahl aufweisen.

5. Schaltung nach Anspruch 4, **dadurch gekennzeichnet,** daß die Primär- und Sekundärwicklung (PW, SW) des Impuls-Übertragers (T) auf den Kern eines Leistungs-Übertragers derart aufgebracht sind, daß die Impulsübertragung von dem Magnetfluß des Leistungs-Übertragers unbeeinflußt bleibt.

6. Schaltungsanordnung nach einem der Ansprüche 1 bis 4,
**dadurch gekennzeichnet,** daß die Primär- und Sekundärwicklung des Impuls-Übertragers (T) aus jeweils einer auf einer gedruckten Leiterplatte (LP) aufgebrachten schleifenartigen Leiterbahn (PW, SW) bestehen und daß der Kern des Impuls-Übertragers (T) von einem beide schleifenartigen Leiterbahnen (PW, SW) durchsetzenden Stift (K) aus magnetisch leitendem Material gebildet ist.

7. Schaltung nach einem der vorangehenden Ansprüche,
**dadurch gekennzeichnet,** daß der Impulsformer (B1) von einem Speicherkondensator (SK) gespeist ist, dem über eine Gleichrichterdiode (GD) die Sendeimpulse zugeführt sind.

## Claims

1. Circuit arrangement for the transmission of transmit pulses between two electrically isolated electric circuits having a pulse transformer (T), the primary winding (PW) of which is connected in series by way of a pulse shaper (B1) with a low-capacitance capacitor (C) and connected to the secondary winding (SW) of which there is a threshold value switch (B2) at the output of which the transformer pulses can be tapped, characterised in that the threshold value switch (B2) is positively fed back directly via the secondary winding (SW).

2. Circuit arrangement according to claim 1, characterised in that the threshold value switch is a logic gate.

3. Circuit arrangement according to claim 1 or 2, characterised in that the threshold value switch is a line driver (B2) (buffer).

4. Circuit arrangement according to one of the preceding claims, characterised in that the primary winding and the secondary winding (PW, SW) of the pulse transformer (T) each have a very low number of turns.

5. Circuit arrangement according to claim 4, characterised in that the primary winding and the secondary winding (PW, SW) of the pulse transformer (T) are applied to the core of a power transformer in such a way that the pulse transmission remains unaffected by the magnetic flux of the power transformer.

6. Circuit arrangement according to one of the claims 1 to 4, characterised in that the primary winding and the secondary winding of the pulse transformer (T) consist of, respectively, one loop-like printed conductor (PW, SW) applied to a printed circuit board (LP) and in that the core of the pulse transformer (T) is formed by a pin (K) made of magnetically conductive material passing through both loop-like printed conductors (PW, SW).

7. Circuit arrangement according to one of the preceding claims, characterised in that the pulse shaper (B1) is fed by a storage capacitor (SK) to which the transmit pulses are supplied by way of a rectifier diode (GD).

## Revendications

1. Dispositif de transmission d'impulsions d'émission entre deux circuits isolés galvaniquement, comportant un transformateur d'impulsions (T), dont l'enroulement primaire (PW) est branché en série avec un condensateur (C) de faible capacité, par l'intermédiaire d'un dispositif de mise en forme d'impulsions (B1), et à l'enroulement secondaire (SW) duquel est relié un commutateur (B2) à seuil, à la sortie duquel peuvent être prélevées les impulsions du transformateur, caractérisé par le fait que le commutateur (B2) à seuil est couplé directement par réaction par l'intermédiaire de l'enroulement secondaire (SW).

2. Dispositif suivant la revendication 1, caractérisé par le fait que le commutateur à seuil est une porte logique.

3. Dispositif suivant la revendication 1 ou 2, caractérisé par le fait que le commutateur (B2) à seuil est un transmetteur de ligne (tampon).

4. Dispositif suivant l'une des revendications précédentes, caractérisé par le fait que l'enroulement primaire et l'enroulement secondaire (PW,SW) du transformateur d'impulsions (T) comportent chacun un nombre de spires très petit.

5. Dispositif suivant la revendication 4, caractérisé par le fait que l'enroulement primaire et l'enroulement secondaire (PW,SW) du transformateur d'impulsions (T) sont montés sur le noyau d'un transformateur de puissance de telle sorte que la transmission des impulsions n'est pas influencée par le flux magnétique du transformateur de puissance.

6. Dispositif suivant l'une des revendications 1 à 4, caractérisé par le fait que l'enroulement primaire et l'enroulement secondaire du transformateur d'impulsions (T) sont constitués respectivement d'une voie conductrice (PW,SW) en forme de boucle, qui est disposée sur une plaquette (LP) de circuits imprimés, et que le noyau du transformateur d'impulsions (T) est formé par une tige (K) qui est en un matériau magnétiquement conducteur et qui traverse les deux voies conductrices (PW,SW) en forme de boucles.

7. Dispositif suivant l'une des revendications précédentes, caractérisé par le fait que le transformateur d'impulsions (B1) est alimenté par un condensateur (SK) d'accumulation d'énergie, auquel les impulsions d'émission sont envoyées par l'intermédiaire d'une diode de redressement (GD).
